# EUROPÄISCHE PATENTANMELDUNG

(11) **EP 4 428 739 A1**
(43) Veröffentlichungstag der Anmeldung: **11.09.2024**
(21) Anmeldenummer: 23160656.7
(22) Anmeldetag: 08.03.2023
(51) Int. Cl.: G06F 30/13

(54) **TOPOLOGIE FÜR EIN PERSONENSTROMSIMULATIONSMODELL BASIEREND AUF REALDATEN**

(71) Anmelder: Siemens Schweiz AG, 8047 Zürich (CH)
(72) Erfinder: Klein, Wolfram, 85579 Neubiberg (DE); Mayer, Hermann Georg, 83209 Prien am Chiemsee (DE)
(74) Vertreter: Siemens Patent Attorneys

(57) **Zusammenfassung**

Die Erfindung betrifft ein Verfahren zum Ermitteln einer Topologie für ein Personenstromsimulationsmodell eines Gebietes, wobei mittels Messungen erfasste Bewegungsdaten von Personen vorliegen, welche pro Person mehrere Datenpunkte mit Ortsinformationen des Gebietes umfassen. Aus den Bewegungsdaten werden für Personen zugängliche Wege (PATH 1, PATH 2, PATH 3, PATH 4) innerhalb des Gebietes ermittelt, und zumindest ein Startgebiet (ORIGIN 1) für die Bewegung von Personen innerhalb des Gebietes, und/oder zumindest ein Zielgebiet (DESTINATION 1, DESTINATION 2, DESTINATION 3, DESTINATION 4) für die Bewegung von Personen innerhalb des Gebietes.

## Beschreibung

Die Erfindung betrifft das Ermitteln einer Topologie für ein Personenstromsimulationsmodell eines Gebietes.

Eine Personenstromsimulation ist eine Computersimulation, bei der die Bewegungen von Personen auf der Grundlage eines mathematischen Modells simuliert werden. Vereinfacht ausgedrückt imitieren Personenstromsimulationen das Verhalten einer großen Anzahl von Menschen im räumlichen Gebieten. Hierzu berechnet die Simulation die zeitlich und räumlich gesehen nächste Position einer Person anhand von bestimmten Vorschriften oder maschinengelerntem Vorgehen, wodurch ein menschliches Verhaltensmuster nachgeahmt werden soll. Hierzu können verschiedene Modelle aus dem Bereich der Mikro- bzw. Makromodellierung zum Einsatz kommen. Der Einsatzzweck dieser Simulationen ist vielfältig, ein prominentes Beispiel ist die Berechnung von Evakuierungssituationen.

Dem Personenstromsimulationsmodell muss ein Modell der Topologie desjenigen Gebietes, für welches die Simulation berechnet werden soll, zur Verfügung gestellt werden. Derartige Gebiete können z.B. Gebäude wie Bahnhöfe, Einkaufsmalls oder Stadien sein, oder auch Campusgelände, Bürokomplexe, Wohnblocks, Siedlungen oder ganze Stadtviertel mit einer Mehrzahl von Gebäuden, oder auch Schiffe, Flugzeuge und Züge. Das Topologie Modell gibt üblicherweise in verschiedener Genauigkeit die Lage, Art und Größe von Objekten innerhalb des Gebietes an. Es ist insofern für das Personenstromsimulationsmodell wichtig, als sich hieraus ergibt, auf welche Flächen innerhalb des Gebietes sich Personen bewegen können.

Der Erfindung liegt die Aufgabe zugrunde, ein Verfahren zur Ermittlung der Topologie für ein Personenstromsimulationsmodell aufzuzeigen.

Diese Aufgabe wird durch ein Verfahren mit den Merkmalen des Anspruchs 1 gelöst. Ferner sind Gegenstand der Erfindung eine entsprechende Vorrichtung oder ein System zur Datenverarbeitung, ein entsprechendes Computerprogramm, ein entsprechendes ccomputerlesbares, vorzugsweise nichtflüchtiges, Speichermedium, und ein entsprechendes Übertragungssignal. Vorteilhafte Ausgestaltungen und Weiterbildungen sind Gegenstand von Unteransprüchen.

Das Verfahren dient der einfachen Ermittlung einer Topologie für ein Personenstromsimulationsmodell eines Gebietes. Es liegen hierzu Bewegungsdaten von Personen vor, welche mittels Messungen erfasst wurden. Pro Person umfassen die Bewegungsdaten mehrere Datenpunkte mit Ortsinformationen des Gebietes. Aus den Bewegungsdaten werden ermittelt:
- für Personen zugängliche Wege innerhalb des Gebietes, und
- zumindest ein Startgebiet und/oder zumindest ein Zielgebiet für die Bewegung von Personen innerhalb des Gebietes.

Die mit dem Verfahren ermittelte Topologie basiert auf Realdaten, d.h. tatsächlich gemessenen Daten. Diese Messungen betreffen jeweils einzelne Personen, deren vollzogene Bewegungen innerhalb des Gebietes sie wiedergeben. Es ist pro Person eine Mehrzahl von Datenpunkten vorhanden, wobei jeder Datenpunkt als Ortsinformation einen Ort innerhalb des Gebietes angibt.

Die ermittelte Topologie umfasst zumindest zweierlei: erstens zugängliche Wege und zweitens zumindest ein Start- und/oder Zielgebiet. Ein zugänglicher Weg bedeutet, dass sich hier eine Person befinden kann, diese Orte können also nicht durch unzugängliche Objekte wie Hindernisse o.ä. belegt sein. Hierbei impliziert die Zugänglichkeit nicht, dass ein Betreten des jeweiligen Ortes zu Fuß möglich sein muss; auch ein "Betreten" mit Rollstuhl, Fahrrad o.ä. fällt hierunter. Ferner muss es sich bei den für die Topologie als zugänglicher Weg ermittelten Orten nicht um angelegte oder als solche gekennzeichnete Wege handeln; z.B. könnte hierunter auch ein Weg quer über einen Rasenabschnitt oder Parkplatz fallen, welcher sich nicht von dem restlichen Rasenabschnitt bzw. Parkplatz unterscheidet. Ein Startgebiet zeigt an, dass gemäß den Bewegungsdaten hier eine Bewegung einer oder mehrerer Personen begonnen wurde. Typische Startgebiete sind Eingänge von Geländeabschnitten, Haltestellen oder Ausgänge von öffentlichen Verkehrsmitteln, Gebäudeausgänge; typische Zielgebiete entsprechen den Startgebieten weitestgehend, können also z.B. Gebäudeeingänge oder Bahnhöfe sein.

Die zugänglichen Wege können ermittelt werden, indem die den Ortsinformationen der Bewegungsdaten entsprechenden Orte als Bestandteil von zugänglichen Wegen gekennzeichnet werden. Es wird also die Schlussfolgerung gezogen, dass, wenn eine Person bei der Datenerfassung an einem Ort war, dieser Ort Bestandteil eines zugänglichen Weges sein muss. Hierunter fällt auch, dass die Kennzeichnung als zugänglicher Weg erst dann erfolgt, wenn aus den Bewegungsdaten hervorgeht, dass eine bestimmte Mindestanzahl von Personen die entsprechenden Orte betreten hat.

Die Kennzeichnung kann erfolgen, indem auf einer Karte des Gebietes die den Ortsinformationen der Bewegungsdaten entsprechenden Orte markiert werden. Es kommt in diesem Fall eine digitale Karte zum Einsatz, welche außer den als zugängliche Wege markierten Orten weitere Objekte enthalten kann, jedoch nicht muss. Auch das oder die Start/Zielgebiete können hierin markiert werden. Bei der Markierung kann zusätzlich ein Bereich um die den Ortsinformationen der Bewegungsdaten entsprechenden Orte markiert werden. Eine einfache Vorgehensweise, dies umzusetzen, ist das Ziehen von Kreisen oder anderen geometrischen Formen um jeden Ort der Bewegungsdaten. Ferner können für die Kennzeichnung die Bewegungsdaten um nicht mittels Messung erfasste Datenpunkte ergänzt werden, und/oder mittels Messung erfasste Datenpunkte können gelöscht werden. Ersteres bedeutet, dass künstliche Datenpunkte, welche nicht tatsächlich gemessen wurden, bei der Ermittlung der Topologie einbezogen werden; dies ist sinnvoll z.B. bei offensichtlichen Lücken in den Bewegungsdaten. Zweiteres bedeutet, dass nicht alle gemessenen Bewegungsdaten bei der Ermittlung der Topologie verwendet werden müssen; dies ist sinnvoll z.B. bei offensichtlich fehlerhaften Bewegungsdaten oder sehr selten gemessenen Orten, welche insofern als ungewöhnlich angesehen werden.

Die Datenpunkte der Bewegungsdaten umfassen vorzugsweise dreierlei:
- Personenidentifikationsinformationen,
- einen Zeitpunkt der Erfassung des jeweiligen Datenpunktes,
- eine dem Zeitpunkt der Erfassung des jeweiligen Datenpunktes entsprechende Ortsinformation.

Die Personenidentifikationsinformationen müssen hierbei keine Rückschlüsse auf die tatsächliche Identität der Person, für welche die Bewegungsdaten erfasst wurden, ermöglichen; vorzugsweise ist dies sogar ausgeschlossen. Sie dienen dazu, eine personenweise Auswertung der Bewegungsdaten zu ermöglichen, d.h. die Datenpunkte verschiedenen Personen zuzuordnen. Die Zeitpunkte ermöglichen es, die Richtung der Bewegung der Person zu ermitteln und somit Start und Ziel zu unterscheiden. Ferner können hieraus auch Informationen über Personengeschwindigkeiten gewonnen werden; dies ist eine Größe, welche auch in das Personenstromsimulationsmodell Eingang finden kann. Die Art der Angabe der Ortsinformationen und deren Dimension kann hierbei unterschiedlich sein; z.B. eignet sich die Verwendung von zwei- oder dreidimensionalen kartesischen Koordinaten.

Das zumindest eine Startgebiet und/oder das zumindest eine Zielgebiet kann ermittelt werden, indem anhand der Zeitpunkte und der entsprechenden Ortsinformationen Beginn und Ende von Personenbewegungen ermittelt werden. Es wird also betrachtet, an welchem Ort eine Person begonnen hat, sich innerhalb des Gebietes zu bewegen, und wo sie die Bewegung beendet hat. Ein Start- und/oder Zielgebiet kann ein Ort sein, wo zumindest eine Person eine Bewegung begonnen bzw. beendet hat; alternativ kann ein Ort auch dann erst als Start- und/oder Zielgebiet angesehen werden, wenn eine bestimmte Mindestanzahl an Personen hier eine Bewegung begonnen bzw. beendet hat.

Unter Verwendung der Bewegungsdaten mehrerer Personen kann pro Person eine Ermittlung eines Startgebiets und eines Zielgebiets erfolgen, und anhand dessen kann eine Matrix zur Angabe einer anteiligen Verteilung von Kombinationen aus jeweils einem Startgebiet und einem Zielgebiet erstellt werden. Dies kann in Form einer sogenannten Origin-Destination-Matrix angegeben werden. Einer solchen Matrix kann entnommen werden, welcher Anteil aller Personen, für welche die Bewegungsdaten vorliegen, sich von einem jeden der Startgebiete in ein jedes der Zielgebiete bewegt hat.

Unter Verwendung der Topologie kann ein Personenstromsimulationsmodell erstellt werden, dann kann unter Verwendung des Personenstromsimulationsmodells eine Personenstromsimulation ablaufen, und schließlich kann unter Verwendung der Ergebnisse der Personenstromsimulation mindestens eine Maßnahme zur Veränderung der realen Topologie des Gebietes vorgenommen werden. Eine solche Veränderung kann z.B. darin bestehen, dass Hindernisse beseitigt werden, so dass neue Wege eröffnet werden, oder dass Objekte zur gezielten Veränderung der Wege installiert werden. Die Ermittlung der Topologie hat also konkrete Auswirkungen in der realen Welt, indem die von ihr aufgezeigten zugänglichen Wege verändert werden.

Die Bewegungsdaten können über eine auf einem mobilen Kommunikationsgerät befindliche Applikation erfasst werden. Hierbei kann es sich um eine eigens zur Erfassung der Bewegungsdaten erstellte und installierte Applikation handeln; alternativ können auch andere Applikationen, welche ohnehin Bewegungsdaten erfassen, eingesetzt werden, wie z.B. Navigationsapplikationen.

Das erfindungsgemäße Verfahren und/oder eine oder mehrere Funktionen, Merkmale und/oder Schritte des erfindungsgemäßen

Verfahrens und/oder einer seiner Ausgestaltungen können computergestützt ablaufen. Es kann beispielsweise mittels eines oder mehrerer Computer, Prozessoren, anwendungsspezifischer integrierter Schaltungen (ASIC), digitaler Signalprozessoren (DSP) und/oder sogenannter "Field Programmable Gate Arrays" (FPGA) ausgeführt bzw. implementiert werden. Es kann auch zumindest teilweise in einer Cloud und/oder in einer Edge-Computing-Umgebung ausgeführt werden. Für den computergestützten Ablauf kommt eines oder mehrere miteinander zusammenwirkende Computerprogramme zum Einsatz. Werden mehrere Programme verwendet, so können diese gemeinsam auf einem Computer gespeichert und von diesem ausgeführt werden, oder auch auf verschiedenen Computern an verschiedenen Orten. Da dies funktional gleichbedeutend ist, wird vorliegend im Singular "das Computergrogramm" und "der Computer" formuliert.

Im Folgenden wird die Erfindung anhand eines Ausführungsbeispiels näher erläutert. Dabei zeigen:
- Figur 1:: Schritte zur Erstellung eines vereinfachten Modells einer Topologie,
- Figur 2:: ein vereinfachtes Modell einer Topologie,
- Figur 3:: ein Ablaufdiagramm,
- Figur 4:: ein Computer System,
- Figur 5:: eine detailliertere Darstellung eines Computer Systems.

Ein Personenstromsimulationsmodell modelliert die Bewegungen von Menschen in räumlichen Umgebungen. Typische hierbei betrachtete Gebiete sind z.B. Bahnhöfe, Flughäfen, Sportstadien. Durch Ablaufenlassen der Simulation können verschiedene Szenarien betrachtet werden, wie z.B. Evakuierungen von Bürogebäuden oder Hotels im Brandfall, das zeitgleiche Eintreffen einer Vielzahl von Personen in einem begrenzten Gebiet wie z.B. zu Beginn eines Sportereignisses in einem Stadion, oder auch die Auswirkungen von Designänderungen innerhalb von Gebäuden oder öffentlichen Räumen auf Aspekte wie Sicherheit oder Effizienz des Personenverkehrs.

Vor Erstellung eines Modells für eine Personenstromsimulation wird üblicherweise zunächst ein Modell der dem betrachteten Gebiet zugrundeliegenden Topologie erstellt. Diese Topologie ist insofern von Bedeutung für die Personenstromsimulation, als aus ihr hervorgeht, welche Wege von Personen genutzt werden können. Dies ist aufwendig, da Objekte wie Hindernisse, die die Bewegung von Personen einschränken, z.B. Wände, Türen oder Säulen, meist manuell im Modell erstellt werden müssen. Diese manuelle Erstellung erfolgt, indem über eine GUI entsprechende Komponenten modelliert und verknüpft werden. Manche Objekte können zwar aus bestehenden 2D oder 3D Datensätzen importiert werden (CAD oder BIM Daten); jedoch ist i.d.R. eine aufwändige manuelle Nacharbeit notwendig, da die importierten Bestandteile oft zu viele oder zu wenige Details enthalten, oder Daten umfassen, die in der Simulation falsch interpretiert werden können, z.B. könnte unklar sein, ob ein Strich für ein Hindernis oder eine passierbare Schwelle steht. Durch diese manuelle Handhabung steigen der Vorbereitungsaufwand und damit auch die Kosten für die Erstellung einer Simulation beträchtlich.

Außer der Erstellung des Modells der Topologie muss auch das Verhalten der Personen modelliert werden. Dieses Verhalten betrifft sowohl ihre Generierung, also an welchem Ort innerhalb des Gebietes tauchen sie auf und beginnen, sich fortzubewegen, als auch ihr Ziel, also zu welchem Ort bewegt sich die jeweilige Person, und auch die Verteilung, also wie viele Personen bewegen sich von welcher Quelle zu welchem Ziel. Auch dies ist ein aufwendiger manueller Prozess, der sich als fehlerbehaftet herausstellen kann, wenn hierbei getroffene Annahmen von dem realen Bewegungsverhalten der Personen abweichen.

In vielen Fällen ist die entsprechende Infrastruktur, also die Umgebung, in der der Personenstrom simuliert werden soll, in der Realität bereits vorhanden. Dies fällt unter den Begriff der "Simulation @ Operation". Im Folgendem wird vorgestellt, wie ohne Kenntnis der zugrundeliegenden tatsächlichen Topologie dieser bestehenden Umgebung die Grundlagen für ein funktionsfähiges Simulationsmodell abgeleitet werden können. Dies beruht auf Realdaten, also auf der Beobachtung von Personen innerhalb des für die Simulation relevanten Gebietes.

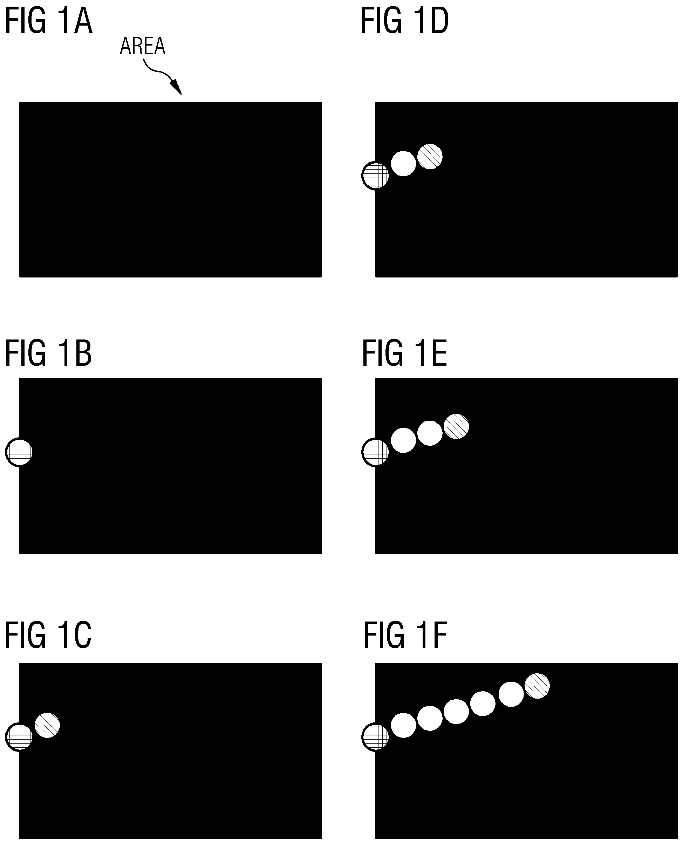

Figur 1 zeigt Schritte zur Erstellung eines vereinfachten Modells einer Topologie. Figur 1a zeigt ein schwarzes Rechteck AREA, welches für das Gebiet steht, für welches die Topologie zu ermitteln ist. Außer der Umrandung sind keinerlei Kenntnisse über die sich hierin befindliche tatsächliche Topologie nötig. Abweichend von der Rechteckform können auch andersartige Polygone oder auch Kreisabschnitte als Grenzen zum Einsatz kommen. Die Punkte innerhalb der Fläche AREA entsprechen Koordinaten (x,y) des realen Gebietes. D.h. es existiert eine geometrische Zuordnung zwischen jedem Ort in der realen Umgebung und einem Punkt innerhalb der Fläche AREA. Zur Vereinfachung der Veranschaulichung wird der Fall betrachtet, dass Personen sich in dem betrachteten Gebiet nur in zwei Dimensionen bewegen. Eine dritte Dimension, entsprechend z.B. Treppen, Fahrstühle und verschiedenen Stockwerken von Gebäuden, kann ergänzt werden, indem anstelle eines Rechtecks AREA ein Quader betrachtet wird. Die Vorgehensweise ist in drei Dimensionen entsprechend zu derjenigen für zwei Dimensionen erläuterten.

Grundlegend ist die Erkenntnis, dass für eine Personenstromsimulation nicht die vollständige Topologie modelliert werden muss, sondern vielmehr ein vereinfachtes Modell dieser Topologie ausreicht, in welchem die von Personen nutzbaren Wege abgebildet sind. Die prinzipielle Idee besteht daher darin, die zulässige betretbare Fläche durch die Beobachtung tatsächlich beobachteter Personenbewegungen einzuschränken. Vorausgesetzt wird, dass im Beobachtungszeitraum ein hoher Anteil der potenziell betretbaren Fläche tatsächlich betreten wird. Dies ist insbesondere in öffentlichen Räumen und Gebäuden zu Stoßzeiten der Fall. Flächen, die auch zu solchen Zeiten oder bei langer Beobachtung nicht betreten werden, können i.d.R. im Modell vernachlässigt werden. Derartige zwar an sich für Menschen zugänglichen aber im Rahmen der Beobachtung nicht betretenen Bereiche können z.B. Nischen oder Bereiche unter Treppen sein. Dadurch, dass diese in dem mittels Beobachtung erstellten Modell der Topologie im Vergleich zu einem genauen Topologie Modell außer Acht gelassen werden, stellt das auf Beobachtung basierende Modell eine Vereinfachung dar, ohne dass hierdurch die Ergebnisse der Personenstromsimulation sich wesentlich verschlechtern.

Es erfolgt also eine Beobachtung des relevanten Gebiets im Normalbetrieb. Die Dauer dieser Beobachtung ist hinreichend lang, so dass alle für die zu erstellende Simulation interessanten Stellen des Gebietes von Personen belaufen wurden. Diese Bewegungsdaten von Personen werden nun ausgewertet. Sie können mittels Videokameras erfasst worden sein, aber auch andere Sensoren zur Überwachung von Personenbewegungen sind einsetzbar. Alternativ ist es möglich, zur Erfassung der Bewegungsdaten auf dem Smartphone installierte Apps zu verwenden. Derartige Daten werden als Mobile tracking data bezeichnet. Ein Beispiel für eine derzeit häufig genutzte App, welche den Standort des Nutzers in kurzen Zeitabständen meldet, ist Google Maps. Die Sensorik und Algorithmen zur Erfassung der Bewegungsdaten sind nicht wesentlich für die beschriebene Vorgehensweise. Es wird davon ausgegangen, dass Bewegungsdaten mit einer Vielzahl von Datenpunkten vorliegen, wobei jeder Datenpunkt aus drei Bestandteilen besteht: erstens dem Zeitpunkt der Erfassung, zweitens einer Personenidentifikation, drittens einem Koordinatentupel (x, y,) oder (x, y, z). Die Personenidentifikation dient hierbei dazu, die Datenpunkte der jeweiligen Person zuzuordnen, und somit eine personenweise Auswertung der Bewegungsdaten vornehmen zu können; es ist keine Möglichkeit des Rückschlusses auf die Identität der jeweiligen Person erforderlich.

Die Bewegungsdaten werden nun personenweise ausgewertet, wie anhand von Figur 1 erläutert wird. Dies wird für jede Personenidentifikation, d.h. für alle Personen aus der Menge der Realdaten, durchgeführt. Es wird der Datenpunkt mit dem frühesten Zeitpunkt gesucht und um das entsprechende Koordinatentupel ein Kreis in der Fläche AREA eingetragen, wie in Figur 1b zu sehen. Der Kreis kann z.B. einen Durchmesser von 2 Metern, bezogen auf die reale Dimensionierung, haben. Dieser Durchmesser ist so gewählt, dass bei Bewegung der Person unterhalb einer vorgegebenen Maximalgeschwindigkeit ein zusammenhängender Bereich entsteht. Die Bewegungsdaten liegen nicht als kontinuierliche Daten vor, sondern werden zu diskreten Zeitpunkten erfasst, z.B. ein Datenpunkt pro Sekunde. Trägt man Kreise entsprechend zeitlich aufeinanderfolgenden Datenpunkten ein, ergibt sich bei nicht allzu großer Geschwindigkeit der Person durch die mehreren nebeneinander liegenden Kreise eine Spur. Ein weiterer Vorteil der Verwendung der Kreise ist, dass hierdurch der Ungenauigkeiten in der Erfassung der Personenposition Rechnung getragen wird.

Der Kreis wird mit einem Karomuster gefüllt, wie in Figur 1b zu sehen. Nun wird der Datenpunkt der betrachteten Person mit dem unmittelbar darauffolgenden Zeitpunkt gesucht. Um die jeweilige Koordinate wird wieder ein Kreis mit dem gleichen Durchmesser eingetragen, wie in Figur 1c gezeigt. Dieser Kreis erhält ein schraffiertes Muster. Im Anschluss wird, s. Figur 1d, ein Kreis um die Koordinate des nächsten Zeitpunktes gebildet. Dieser erhält wieder das Karomuster, während der vorhergehende Kreis weiß gefärbt wird. Dieses Vorgehen wird fortgesetzt, s. Figur 1e, bis schließlich der Kreis mit dem letzten Zeitpunkt eingetragen ist, s. Figur 1f. Der letzte Zeitpunkt kann hierbei z.B. ermittelt werden, dass sich ab diesem Zeitpunkt die Position der Person nicht mehr ändert. Alternativ hierzu ist es möglich, dass ab diesem Zeitpunkt keine Daten mehr zur Verfügung stehen, weil die Erfassung beendet wurde. Letzteres kann sich z.B. dadurch ergeben, dass eine Videoerfassung bei Betreten eines Gebäudes beendet wird, oder dass eine Applikation auf einem Mobilfunkgerät keine Positionsdaten mehr sendet, wenn sich der Nutzer des Gerätes nicht mehr bewegt.

Nun wird die nächste Personenidentifikation verwendet und die Bewegung dieser Person wird entsprechend dem anhand der Figur 1 erläuterten Vorgehen in die Fläche AREA eingetragen. Dieses Vorgehen wird für alle Personen in allen Zeitschritten der Realdaten Menge wiederholt.

Als Ergebnis hat nun die ursprünglich schwarz eingefärbte Topologie eine Menge von weißen Kreisen, auf denen sich mindestens eine Person zu irgendeinem Zeitpunkt während der Erfassung der Bewegungsdaten bewegt hat, sowie pro Person jeweils einen karierten und einen schraffierten Kreis. Umgekehrt gilt, dass in den noch schwarz gefärbten Gebieten im Beobachtungszeitraum sich nie jemand bewegt hat.

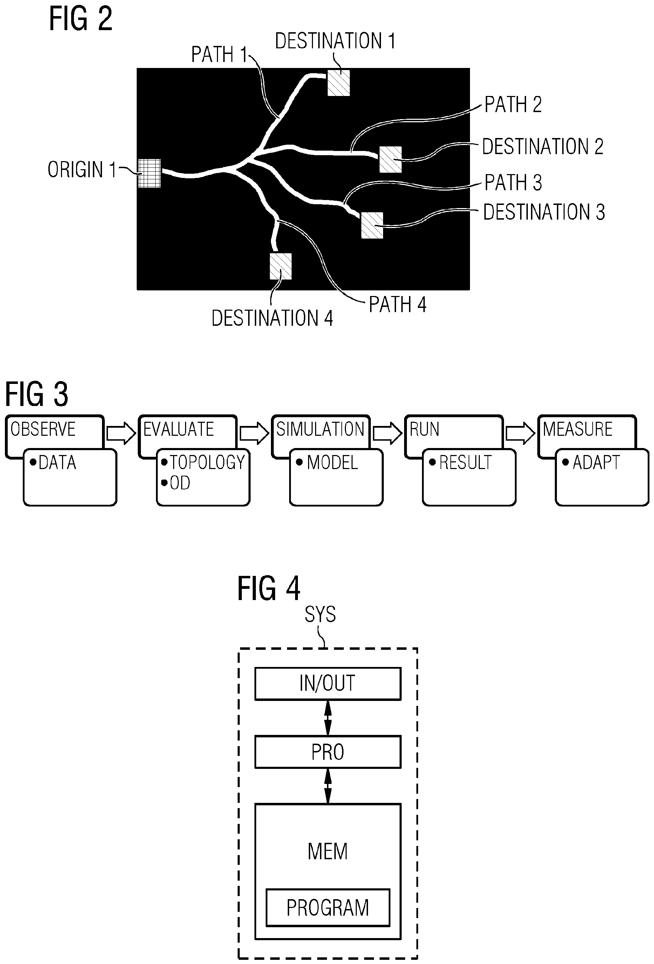

Figur 2 zeigt die vereinfachte Topologie, welche sich als Ergebnis dieses Vorgehens ergibt. Der Maßstab ist hierbei anders als in Figur 1 gewählt, da letztere lediglich auf die Erläuterung hinsichtlich der Bewegung einer einzelnen Person ausgerichtet ist. Die weißen Linien in Figur 2 zeigen die Wege PATH 1, PATH 2, PATH 3, PATH 4, welche von Personen im Beobachtungszeitraum genutzt wurden. Die prinzipielle Idee ist also das Einfärben von Flächen der zugrundeliegenden Topologie mittels zweier Farben, z.B. schwarz und weiß, je nachdem ob eine Person diese Fläche jemals betreten hat (dies entspricht in den Figuren der weißen Farbe) oder nicht (dies entspricht in den Figuren der schwarzen Farbe). Eine Darstellung wie in Figur 2 könnte sich z.B. daraus ergeben, dass Personen mit einem öffentlichen Verkehrsmittel an einem Gelände ankommen, wobei das Startgebiet ORIGIN 1 dem Bahnhofsausgang entspricht, um sich auf den Wegen PATH 1, PATH 2, PATH 3, PATH 4 zu verschiedenen Bürogebäuden DESTINATION 1, DESTINATION 2, DESTINATION 3, DESTINATION 4 zu bewegen.

Bei der Erfassung der Bewegungsdaten kann es vorkommen, dass Personen über einen bestimmten Zeitraum keine Daten senden, z.B. weil sie sich in einem Tunnel o.ä. befinden oder die Netzanbindung des Smartphones aus anderem Grund beeinträchtigt ist, aber danach wieder Daten zu dieser Person vorliegen. In diesem Fall von großen Zeitschritten zwischen benachbarten Datenpunkten kann das jeweils letzte und neue Personendatum geographisch und zeitlich interpoliert werden, im einfachsten Fall linear. Auf diese Weise werden die Realdaten also um errechnete Datenpunkte ergänzt. Sollte dies oftmals der Fall sein, kann auch der verwendete Kreisdurchmesser für alle Personen vergrößert werden. Diese Vorgehensweise der Durchmesservergrößerung bietet sich auch an, wenn die Personen sich so schnell bewegen, dass Kreise von zeitlich benachbarten Datenpunkten weder überlappen noch sich berühren.

Umgekehrt kann auch ein Löschen von Datenpunkten durchgeführt werden, welche aufgrund ihrer Positionsangabe einen Fehler in der Datenerfassung oder -übermittlung nahelegen. Dies kann im Sinne eines Plausibilitätschecks durchgeführt werden, um mögliche Ausreißer in der Datenerfassung zu eliminieren. Auf diese Weise können z.B. Punkte gelöscht werden, die nicht in räumlichem Zusammenhang mit anderen Datenpunkten stehen. Weitergehend können auch Datenpunkte oder sogar Wege gelöscht werden, welche nur einmal von einer Person betreten wurden, und nicht von anderen Personen.

Somit liegt das vereinfachte Modell der Topologie vor, welches für die Personenstromsimulation verwendet werden kann. Es sind alle benötigten geografischen Informationen ermittelt, indem die von Personen verwendbaren Wege umfassend vorliegen. Weitergehende topologische Informationen werden nicht benötigt.

Zusätzlich zum Modell der Topologie ist für eine Personenstromsimulation das Vorliegen einer Origin-Destination-Matrix sinnvoll. Diese OD-Matrix ist eine Tabelle, welche Flüsse von Personen von einem Ausgangsort (englisch: Origin) zu einem Zielort (englisch: Destination) angibt. In der OD-Matrix werden die verschiedenen Ausgangsorte oder Personen-Quellen in den Spalten und die Personen-Ziele in den Zeilen dargestellt, wobei in die Zellen die entsprechenden Flussmengen eingetragen werden. Die Ermittlung der OD-Matrix basierend auf den Bewegungsdaten kann folgendermaßen vorgenommen werden:
Wie bereits erläutert liegt zusätzlich zu den weißen Kreisen pro Person jeweils ein karierter Kreis vor, in dem sie zum ersten Mal aufgetreten ist bzw. ihre Bewegung begonnen hat, sowie ein schraffierter Kreis, in dem sie das letzte Mal aufgetreten/verschwunden ist bzw. ihre Bewegung beendet hat. Diese gemusterten Kreise dienen dem Identifizieren von Gebieten für Personen-Quellen und Personen-Zielen. Es wird hierzu für alle karierten Kreise, die sich überlappen, ein diese umschließender "Superkreis" gebildet. Dieser "Superkreis" kann eine beliebige Form haben, z.B. ein Polygon. In Figur 2 ist die die karierten Kreise umschließende Form als Rechteck ORIGIN 1 eingetragen. Bei mehreren sich überlappenden Clustern von karierten Kreisen wird entsprechend eine Mehrzahl derartiger umhüllender Formen gebildet. Auf die gleiche Weise wird für die schraffierten Kreise vorgegangen; in Figur 2 sind die vier Zielgebiete DESTINATION 1, DESTINATION 2, DESTINATION 3, DESTINATION 4 eingetragen. Damit sind nun verschiedene Start- bzw. Zielgebiete definiert mit "weißen Wegen" dazwischen, welche anzeigen, dass hier Zugänglichkeit für Personen gegeben ist.

Es wird eine Liste mit Personenidentifikationen gespeichert, und zwar für jede Personen-Quelle eine Liste derjenigen Personen, die in diesem Startgebiet gestartet sind, und für jedes Personen-Ziel eine Liste derjenigen Personen, die in diesem Zielgebiet angekommen sind. Anhand dieser Informationen kann ermittelt werden, wieviel Prozent der Personen von welcher Personen-Quelle zu welchem Personen-Ziel gelaufen ist. Somit kann anhand der gespeicherten Personenidentifikationen pro Start und Ziel identifiziert werden, welcher Anteil aller Personen sich von wo nach wo bewegt hat, womit die OD-Matrix aufgestellt werden kann.

Über das aufgezeigte Verfahren kann basierend auf realen Bewegungsdaten von Personen einerseits ein vereinfachtes topologisches Modell für das betrachtete Gebiet erstellt werden, und andererseits eine OD-Matrix. Hiermit kann dann ein Modell für eine Personenstromsimulation aufgestellt werden. Hierzu sind ferner Annahmen über die Bewegungsgeschwindigkeit der Personen zu treffen; dies kann aus den Bewegungsdaten abgeleitet werden, oder aus zu Personenbewegungsgeschwindigkeiten verfügbaren Literaturdatensätzen.

Zusammenfassend zeigt Figur 3 ein Ablaufdiagramm zu dem geschilderten Vorgehen. Das für eine zu erstellende Personenstromsimulation relevante Gebiet wird im Schritt OBSERVE im Normalbetrieb beobachtet, so dass Bewegungsdaten DATA von Personen vorliegen. Diese Bewegungsdaten DATA werden im Schritt EVALUATE wie anhand der Figuren 1 und 2 erläutert ausgewertet. Als Ergebnis der Auswertung liegt die vereinfachte Topologie TOPOLOGY vor, welche für Personen zugängliche Wege innerhalb des Gebiets anzeigt, sowie die Origin-Destination-Matrix OD. Basierend hierauf kann im Schritt SIMULATION ein Modell MODEL für eine Personenstromsimulation erstellt werden. Die Personenstromsimulation kann schließlich im Schritt RUN ablaufen und Ergebnisse RESULT ausgeben. Basierend auf den Ergebnissen RESULT der Personenstromsimulation können im Schritt MEASURE Maßnahmen getroffen werden, wie z.B. eine Maßnahme ADAPT zur Änderung der realen Topologie.

Die beschriebene Vorgehensweise kann computergestützt ablaufen. Figur 4 zeigt, wie ein hierfür geeignetes das System SYS aufgebaut sein kann. Während die im Folgenden näher erläuterten Bestandteile in der Figur einfach vorhanden sind, ist es auch möglich, dass diese in mehrfacher Ausführung vorhanden sind, z.B. als verteiltes System. Auf diese Weise kann die Funktionalität des Systems SYS auf mehrere, gegebenenfalls hierarchisch miteinander verknüpfte, Systeme aufgeteilt werden.

Das System SYS umfasst eine Recheneinheit bzw. einen Prozessor PRO. Dieser ist verbunden mit einem Speicher MEM, in welchem ein Computerprogramm PROGRAM abgelegt ist. Bei dem Speicher MEM handelt es sich vorzugsweise um ein nicht-flüchtiges computerlesbares Datenspeichermedium. Die Speicherung kann auf jegliche Weise erfolgen, welche geeignet ist, die Auslesbarkeit durch eine Recheneinheit zu gewährleisten, wie durch magnetische Speicherung, z.B. mittels Diskette, optische Speicherung, z.B. mittels CD, magneto-optische Speicherung, ROM (Read Only Memory) Speicherung, RAM (Random Access Memory) Speicherung, EPROM (Erasable Programmable Read-Only Memory), EEPROM (Electrically Erasable Programmable Read-Only Memory), Flash-Memory.

Durch Ausführen der Instruktionen des Programms PROGRAM in dem Prozessor PRO werden die Schritte der oben erläuterten Vorgehensweise durchgeführt. Dies betrifft insbesondere den Schritt EVALUATE, welcher der Ermittlung der vereinfachten Topologie und der OD-Matrix dient. Die anderen Schritte können von dem gleichen oder einem anderen Computersystem durchgeführt werden. Hierzu ist der Prozessor PRO mit einer Ein- und Ausgabeeinheit IN/OUT verbunden, über welche Informationen zwischen dem System SYS und anderen Komponenten und/oder einem Nutzer ausgetauscht werden können. Z.B. können hierüber Bewegungsdaten von Personen eingegeben und die vereinfachte Topologie und die OD-Matrix ausgegeben werden. Diese Schnittstelle kann hierbei auf geeignete Weise ausgestaltet sein, z.B. über Funk oder über Kabel, und die Kommunikation kann über geeignete Standards erfolgen.

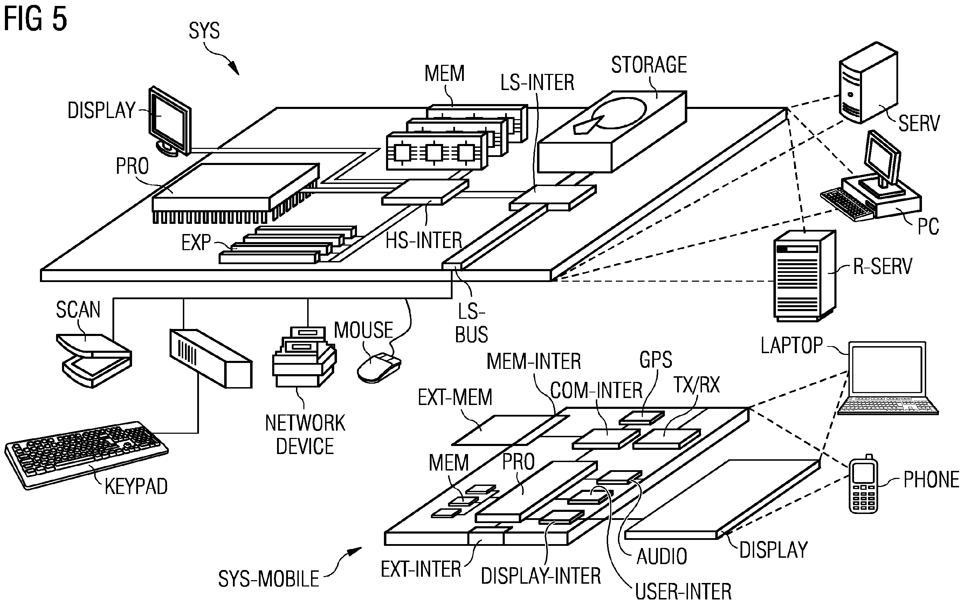

Figur 5 zeigt beispielhaft, wie das System der Figur 4 ausgestaltet sein kann: dies kann ein generischer Computer SYS oder ein mobiler generischer Computer SYS-MOBILE sein. Hierbei repräsentiert der generischer Computer SYS verschiedene Arten digitaler Computergeräte, so wie z.B. Desktopcomputer,

Workstations, Server, Blade Server, Mainframes, oder andere geeignete Geräte. Der mobile generische Computer SYS-MOBILE steht entsprechend für verschiedene Arten mobiler digitaler Computergeräte, so wie z.B. Laptops, PDAs, Mobiltelefone oder Smart Phones, oder andere geeignete Geräte. Wenn anhand von Figur 5 konkret und detailliert verwendbare Komponenten aufgezeigt und erläutert werden, ist dies beispielhaft zu verstehen; die Realisierung der Erfindung ist nicht auf diese Komponenten beschränkt.

Der Computer SYS umfasst einen Prozessor PRO, einen Speicher MEM, und dazwischen ein Hochgeschwindigkeits-Interface HS-INTER. Ferner sind Hochgeschwindigkeits-Expansion Ports EXP und ein Low-speed-Interface LS-INTER an das Hochgeschwindigkeits-Interface HS-INTER angeschlossen. An das Low-speed-Interface LS-INTER sind das Speichergerät STORAGE und der Low-speed Bus LS-BUS angeschlossen. Die Komponenten PRO, MEM, STORAGE, HS-INTER, EXP, LS-INTER sind über geeignete Verbindungen/Busse verbunden, und können auf einem gemeinsamen Motherboard montiert sein.

Während in Figur 5 die Komponenten des Computers SYS in einfacher Ausführung dargestellt sind, ist es auch möglich, manche oder alle dieser Komponenten mehrfach vorzusehen. Auch kann der Computer SYS mehrere miteinander verbundene Computer umfassen, welche sich gegebenenfalls an verschiedenen Orten befinden.

Der Prozessor PRO kann Instruktionen verarbeiten, die im Computer SYS ausgeführt werden sollen, wobei die Instruktionen insbesondere im Speicher MEM oder im Speichergerät STORAGE gespeichert sein können. Informationen, insbesondere Ergebnisse der Verarbeitung im Prozessor PRO, können mittels einer GUI auf einer an das Hochgeschwindigkeits-Interface HS-INTER angeschlossene Anzeige wie dem Bildschirm DISPLAY grafisch ausgegeben werden.

Der Speicher MEM dient der Speicherung von Informationen innerhalb des Computers SYS. Hierbei kann es sich um einen flüchtigen Speicher oder einen nicht-flüchtigen Speicher handeln. Er kann mehrere Speicherzellen umfassen. Bei dem Speichergerät STORAGE handelt es sich vorzugsweise um ein Massenspeichergerät für ein computerlesbares Medium. Hierzu kann es z.B. ein Diskettenlaufwerk, eine Festplatte, ein Laufwerk für optische Speicherplatten, ein Bandgerät, ein Flash Memory-Speichergerät, oder auch eine Reihe von Geräten, z.B. in einer Storage Area Networks Konfiguration, umfassen.

Das Hochgeschwindigkeits-Interface HS-INTER ist zuständig für Bandbreiten-intensive Vorgänge innerhalb des Computers SYS, während das Low-speed-Interface LS-INTER für solche mit geringerem Bandbreitenbedarf verwendet wird. Hierzu ist das Hochgeschwindigkeits-Interface HS-INTER verbunden mit dem Speicher MEM, dem Bildschirm DISPLAY, gegebenenfalls über einen Grafikprozessor, den Hochgeschwindigkeits-Expansion Ports EXP, welche diverse Erweiterungskarten aufnehmen können. An das Low-speed-Interface LS-INTER angebunden sind das Speichergerät STORAGE und der Low-speed Bus LS-BUS, an welchem sich Low-Speed-Expansion Ports befinden können. Letztere können verschiedene Kommunikationsanschlüsse aufweisen, z.B. USB, Bluetooth, Ethernet, drahtloses Ethernet. An diese können diverse Ein- und/oder Ausgabevorrichtungen angeschlossen sein, z.B. eine Tastatur KEYPAD, eine Maus MOUSE, ein Scanner SCAN, ein Netzwerkgerät NETWORK DEVICE wie ein Switch oder ein Router. Diese Aufgabenverteilung zwischen den beiden Interfaces HS-INTER und LS-INTER ist beispielhaft und kann auch anders organisiert sein.

Der Computer SYS kann auf verschiedene Arten implementiert sein, wie am rechten Rand der Figur zu sehen ist. Z.B. kann er implementiert sein als ein Personal Computer PC, als ein Standard-Server SERV, oder auch als eine Gruppe solcher Sever wie z.B. eine Serverfarm, oder als ein Rack-Server-System R-SERV oder Bestanteil eines solchen Systems.

Der mobile Computer SYS-MOBILE umfasst einen Prozessor PRO, einen Speicher MEM, eine Ein- und Ausgabevorrichtung DISPLAY, ein Kommunikations-Interface COM-INTER, einen Transceiver TX/RX. Die Komponenten PRO, MEM, COM-INTER, TX/RX sind über geeignete Verbindungen/Busse verbunden, und können auf einem gemeinsamen Motherboard oder in anderer geeigneter Weise montiert sein. Ferner kann eine weitere Speichereinrichtung, wie z.B. ein Mikrodrive o.ä., vorgesehen sein, um weitere Speicherungsmöglichkeit zu schaffen.

Der Prozessor PRO kann Instruktionen innerhalb des mobilen Computers SYS-MOBILE ausführen, insbesondere solche, die im Speicher MEM abgelegt sind. Er kann als Chip oder Chipset implementiert sein, welcher eine oder mehrere analoge oder digitale Prozesseinheiten enthält. Zuständig kann der Prozessor PRO u.a. sein für die Koordination der anderen Komponenten des mobilen Computers SYS-MOBILE, so z.B. für die Steuerung der Benutzerschnittstelle(n), für Applikationen, welche auf dem mobilen Computers SYS-MOBILE laufen, und für die drahtlose Kommunikation des mobilen Computers SYS-MOBILE. Zwischen dem Nutzer des mobilen Computers SYS-MOBILE und dem Prozessor PRO findet eine Informationsübertragung statt über das Nutzer-Interface USER-INTER, beispielsweise über Sprach-Ein/Ausgabe, sowie über das Display-Interface DISPLAY-INTER, beispielsweise über Text- Ein/Ausgabe. Die Ein- und Ausgabevorrichtung DISPLAY kann z.B. auf der TFT LCD (Thin-Film-Transistor Liquid Crystal Display) oder der OLED (Organic Light Emitting Diode) Technologie basieren.

Ferner ist ein an den Prozessor PRO angebundenes externes Interface EXT-INT vorgesehen, über welches eine Nahfeldkommunikation des mobilen Computers SYS-MOBILE mit anderen Geräten möglich ist. Über das externe Interface EXT-INT kann drahtgebunden und/oder über Funk kommuniziert werden.

Der Speicher MEM dient der Speicherung von Informationen innerhalb des mobilen Computers SYS-MOBILE und kann hierzu z.B. als flüchtiger oder nicht-flüchtiger Speicher umfassend eine oder mehrere Speichereinheiten implementiert sein. Zusätzlich kann ein Erweiterungsspeicher EXT-MEM vorgesehen sein, welches mit dem mobilen Computer SYS-MOBILE über das Erweiterungs-Interface MEM-INTER verbunden ist, z.B. eine Schnittstelle für ein SIMM (Single In Line Memory Module) oder ein SIM (Subscriber Identity Module). Der Erweiterungsspeicher EXT-MEM bietet zusätzliche Speicherkapazität für den mobilen Computer SYS-MOBILE und kann auch diverse Applikationen speichern. Z.B. kann der Erweiterungsspeicher EXT-MEM als Sicherheitsmodul für den mobilen Computer SYS-MOBILE dienen, indem Identifikationsinformationen dort abgelegt werden.

Der mobile Computer SYS-MOBILE kann drahtlos über den Transceiver TX/RX kommunizieren, welcher hierzu über Mittel zur digitalen Signalverarbeitung verfügt. Das Kommunikations-Interface COM-INTER ermöglicht die Kommunikation über geeignete Protokolle, wie z.B. GSM, SMS, MMS, CDMA, TDMA, PDC, WCDMA, CDMA2000, GPRS, EDGE, UMTS, LTE, sowie Kommunikationsprotokolle der 5ten oder höherer Generationen. Zusätzlich zum hierfür verwendeten Transceiver TX/RX kann ein nicht dargestellter Transceiver für Nahfeldkommunikation wie z.B. Bluetooth, WiFi o.ä. vorgesehen sein. Schließlich kann auch ein GPS-Modul GPS vorgesehen sein, um ortsbezogene Dienste verwenden zu können. Mittels des Audio-Codec AUDIO können empfangene Audioinformationen, welche insbesondere Instruktionen eines Nutzers umfassen können, in vom mobilen Computer SYS-MOBILE verarbeitbare digitale Informationen umgewandelt werden; entsprechend können unter Verwendung des Audio-Codec AUDIO vom Nutzer erfassbare Klanginformationen generiert werden.

Wie auf der rechten Seite der Figur zu sehen, ist der mobile Computer SYS-MOBILE vorzugsweise als Smartphone PHONE oder Laptop LAPTOP implementiert.

Die Interaktion zwischen dem Nutzer und dem Computer SYS oder dem mobilen Computer SYS-MOBILE kann auf verschiedenste Weise erfolgen und ist nicht auf die konkrete Darstellung der Figur 5 beschränkt. Jegliche sensorische Informationsübermittlung (sichtbar, hörbar, taktil wahrnehmbar) ist möglich.

Während die Komponenten des Computers SYS und des mobilen Computers SYS-MOBILE getrennt beschrieben wurden, ist es auch möglich, einen Computer einzusetzen, welcher sowohl Komponenten des Computers SYS, als auch des mobilen Computers SYS-MOBILE umfasst.

Das in Figur 4 gezeigte Computerprogramm PROGRAM kann in jedem der Speicher MEM, STORAGE, EXT-MEM der Figur 5 abgelegt sein, auch verteilt auf mehrere Speicher. Ferner kann eine Speicherung alternativ oder zusätzlich auch Cloud-basiert erfolgen.

Die Erfindung wurde voranstehend an einem Ausführungsbeispiel beschrieben. Es versteht sich, dass zahlreiche Änderungen und Modifikationen möglich sind, ohne dass der Rahmen der Erfindung verlassen wird.

## Patentansprüche

1. Verfahren zum Ermitteln einer Topologie für ein Personenstromsimulationsmodell eines Gebietes, wobei mittels Messungen erfasste Bewegungsdaten von Personen vorliegen, welche pro Person mehrere Datenpunkte mit Ortsinformationen des Gebietes umfassen, aus den Bewegungsdaten ermittelt werden:
- für Personen zugängliche Wege (PATH 1, PATH 2, PATH 3, PATH 4) innerhalb des Gebietes, und
- zumindest ein Startgebiet (ORIGIN 1) für die Bewegung von Personen innerhalb des Gebietes, und/oder zumindest ein Zielgebiet (DESTINATION 1, DESTINATION 2, DESTINATION 3, DESTINATION 4) für die Bewegung von Personen innerhalb des Gebietes.

2. Verfahren nach Anspruch 1, bei dem
die zugänglichen Wege (PATH 1, PATH 2, PATH 3, PATH 4) ermittelt werden, indem die den Ortsinformationen der Bewegungsdaten entsprechenden Orte als Bestandteil von zugänglichen Wegen (PATH 1, PATH 2, PATH 3, PATH 4) gekennzeichnet werden.

3. Verfahren nach Anspruch 2, bei dem
die Kennzeichnung erfolgt, indem auf einer Karte (AREA) des Gebietes die den Ortsinformationen der Bewegungsdaten entsprechenden Orte markiert werden.

4. Verfahren nach Anspruch 3, bei dem
bei der Markierung zusätzlich ein Bereich um die den Ortsinformationen der Bewegungsdaten entsprechenden Orte markiert wird.

5. Verfahren nach einem der Ansprüche 2 bis 4, bei dem für die Kennzeichnung die Bewegungsdaten um nicht mittels Messung erfasste Datenpunkte ergänzt werden, und/oder mittels Messung erfasste Datenpunkte gelöscht werden.

6. Verfahren nach einem der Ansprüche 1 bis 5, bei dem die Datenpunkte der Bewegungsdaten umfassen:
- Personenidentifikationsinformationen,
- einen Zeitpunkt der Erfassung des jeweiligen Datenpunktes,
- eine dem Zeitpunkt der Erfassung des jeweiligen Datenpunktes entsprechende Ortsinformation.

7. Verfahren nach Anspruch 6, bei dem
das zumindest eine Startgebiet (ORIGIN 1) und/oder das zumindest eine Zielgebiet (DESTINATION 1, DESTINATION 2, DESTINATION 3, DESTINATION 4) ermittelt wird, indem anhand der Zeitpunkte und der entsprechenden Ortsinformationen Beginn und Ende von Personenbewegungen ermittelt werden.

8. Verfahren nach einem der Ansprüche 1 bis 7, bei dem unter Verwendung der Bewegungsdaten mehrerer Personen pro Person eine Ermittlung eines Startgebiets (ORIGIN 1) und eines Zielgebiets (DESTINATION 1, DESTINATION 2, DESTINATION 3, DESTINATION 4) erfolgt,
und anhand dessen eine Matrix zur Angabe einer anteiligen Verteilung von Kombinationen aus jeweils einem Startgebiet (ORIGIN 1) und einem Zielgebiet (DESTINATION 1, DESTINATION 2, DESTINATION 3, DESTINATION 4) erstellt wird.

9. Verfahren nach einem der Ansprüche 1 bis 8, bei dem unter Verwendung der Topologie ein Personenstromsimulationsmodell (MODEL) erstellt wird (SIMULATION), unter Verwendung des Personenstromsimulationsmodells eine Personenstromsimulation abläuft (RUN), und unter Verwendung der Ergebnisse (RESULT) der Personenstromsimulation mindestens eine Maßnahme (MEASURE) zur Veränderung der realen Topologie des Gebietes vorgenommen wird (ADPAT).

10. Verfahren nach einem der Ansprüche 1 bis 9, bei dem die Bewegungsdaten über eine auf einem mobilen Kommunikationsgerät befindliche Applikation erfasst werden.

11. Vorrichtung oder System zur Datenverarbeitung (SYS), umfassend Mittel zur Ausführung des Verfahrens nach einem der Ansprüche 1 bis 10.

12. Computerprogramm (PROGRAM), umfassend Befehle, die bei der Ausführung des Programms durch einen Computer diesen veranlassen, die Schritte des Verfahrens nach einem der Ansprüche 1 bis 10 auszuführen.

13. Computerlesbares Speichermedium (MEM) mit einem Computerprogramm (PROGRAM) nach Anspruch 12.

14. Übertragungssignal, das das Computerprogramm (PROGRAM) nach Anspruch 12 überträgt.
